## Europäisches Patentamt

## European Patent Office

## Office européen des brevets

(19)

(11) Numéro de publication: **0 112 238**
**A2**

(12)

# DEMANDE DE BREVET EUROPEEN

(21) Numéro de dépôt: 83402341.8

(22) Date de dépôt: 05.12.83

(51) Int. Cl.$^3$: **H 01 J 37/317**
**H 01 L 21/265, H 01 J 27/20**

(30) Priorité: 10.12.82 FR 8220720

(43) Date de publication de la demande:
27.06.84 Bulletin 84/26

(84) Etats contractants désignés:
DE GB NL

(71) Demandeur: COMMISSARIAT A L'ENERGIE ATOMIQUE
Etablissement de Caractère Scientifique Technique et
Industriel
31/33, rue de la Fédération
F-75015 Paris(FR)

(72) Inventeur: Bruel, Michel
Lotissement Presvert No 9
F-38113 Veurey Voroize(FR)

(72) Inventeur: Soubie, Alain
3, rue Casimir Brenier
F-38120 Saint Egreve(FR)

(72) Inventeur: Spinelli, Philippe
24, rue Boileau
F-38700 La Tronche(FR)

(74) Mandataire: Mongrédien, André et al,
c/o BREVATOME 25, rue de Ponthieu
F-75008 Paris(FR)

(54) Procédé et dispositif d'implantation de particules dans un solide.

(57) L'invention concerne un procédé et un dispositif d'implantation de particules dans un solide.

Le procédé d'implantation de particules dans un solide dans lequel on crée un faisceau parallèle (11) de particules énergétiques A, on place sur le chemin de ce faisceau parallèle (11) de particules énergétiques A des particules B qui, par interaction avec les particules énergétiques A, sont projetées vers une cible (6) avec une énergie suffisante pour y pénétrer, est caractérisé en ce que les particules B sont à l'état gazeux, ce gaz (24) occupant une zone située en regard de la cible (6).

Cette invention trouve notamment son application dans le dopage des semiconducteurs.

FIG.1

EP 0 112 238 A2

La présente invention a pour objet un procédé et un dispositif d'implantation de particules dans un solide. Elle trouve notamment son application dans le dopage des semiconducteurs en particulier pour la réalisation de transistors MOS et pour la réalisation de résistance de faibles valeurs dans les circuits bipolaires.

Une méthode d'implantation de particules dans un solide, connue de l'homme de l'art, est l'implantation ionique. Dans cette méthode, on crée dans une source d'ions les ions de l'espèce que l'on désire implanter dans le solide. On forme ensuite un faisceau de ces ions que l'on accélère pour leur communiquer l'énergie suffisante pour pénétrer dans le solide.

Un inconvénient important de cette méthode réside dans le fait qu'il est difficile d'obtenir un faisceau d'ions pur, c'est-à-dire un faisceau d'ions ne contenant que les ions à implanter dans le solide. En effet la source d'ions, qui produit des ions par exemple de manière classique par une décharge électrique dans un gaz, produit indifféremment les ions de l'espèce que l'on désire implanter dans le solide et d'autres ions. Il est alors nécessaire d'effectuer un tri des ions produits pour n'accélérer que ceux que l'on désire implanter dans le solide.

Un procédé connu dérivé de l'implantation ionique est l'implantation par recul. Dans cette méthode, on recouvre le solide d'une mince couche de l'élément que l'on désire y implanter. Un faisceau de particules primaires énergétiques, par exemple des ions argon, est ensuite dirigé vers ce solide. Ces particules primaires énergétiques heurtent les atomes de la couche mince et leur transfèrent ainsi leur énergie, ce qui permet aux atomes de la couche mince de pénétrer dans le solide.

B 7735.3 BL

Cette méthode d'implantation par recul est limitée principalement par l'érosion ionique de la couche mince déposée sur le solide à mesure que l'implantation se déroule. La disparition de cette couche limite les doses de particules que l'on peut implanter dans le solide.

La présente invention a justement pour but de remédier à ces inconvénients en remplaçant dans la méthode d'implantation par recul la couche mince de particules à implanter par un gaz de particules à implanter situé en regard du solide.

De façon plus précise l'invention a pour objet un procédé d'implantation de particules dans un solide dans lequel on crée un faisceau sensiblement parallèle de particules énergétiques A, on place sur le chemin de ce faisceau sensiblement parallèle de particules énergétiques A des particules B qui, par interaction avec les particules énergétiques A, sont projetées vers la cible avec une énergie suffisante pour y pénétrer, qui se caractérise en ce que les particules B sont à l'état gazeux, ce gaz occupant une zone située en regard de la cible.

Selon une variante préférée, la direction du faisceau sensiblement parallèle de particules énergétiques A est à peu près perpendiculaire à la surface de la cible.

Selon une caractéristique secondaire, les particules A sont électriquement chargées.

Selon une autre caractéristique secondaire, les particules B sont électriquement neutres.

L'invention a également pour objet un dispositif d'implantation de particules dans un solide comprenant dans une enceinte sous vide un support de cible, une cible solide, caractérisé en ce qu'il comprend en outre une source de particules énergétiques A délivrant un faisceau sensiblement parallèle de particules énergétiques A, une source de particules B à implanter, un

B 7735.3 BL

moyen de confinement des particules B communiquant avec la source de particules B, comportant une ouverture primaire pour recevoir le faisceau sensiblement parallèle de particules énergétiques A et une ouverture secondaire pour permettre aux particules B de recul d'atteindre la cible.

Selon un mode de réalisation préféré, le moyen de confinement est de forme générale cylindrique, de génératrices parallèles à la direction du faisceau sensiblement parallèle de particules énergétiques A et il comprend un appendice formant réceptacle de la source de particules B.

Selon une caractéristique secondaire, le moyen de confinement comprend un moyen de chauffage du gaz de particules B.

Selon une autre caractéristique secondaire, le moyen de confinement est muni de moyens de refroidissement pour condenser le gaz de particules B.

Selon une autre caractéristique secondaire, le moyen de confinement est muni d'un multicollimateur entre l'ouverture primaire et la zone où règne le gaz de particules B et d'un autre multicollimateur entre cette zone et l'ouverture secondaire.

Selon une autre caractéristique secondaire, les deux multicollimateurs sont alignés.

D'autres caractéristiques et avantages de l'invention ressortiront mieux de la description qui va suivre, donnée à titre illustratif mais non limitatif, en référence aux dessins annexés dans lesquels

- la figure 1 représente un mode de réalisation du dispositif selon l'invention ;
- la figure 2 représente une coupe transversale d'un multicollimateur ;
- la figure 3 représente un mode de réalisation particulier du moyen de confinement.

B 7735.3 BL

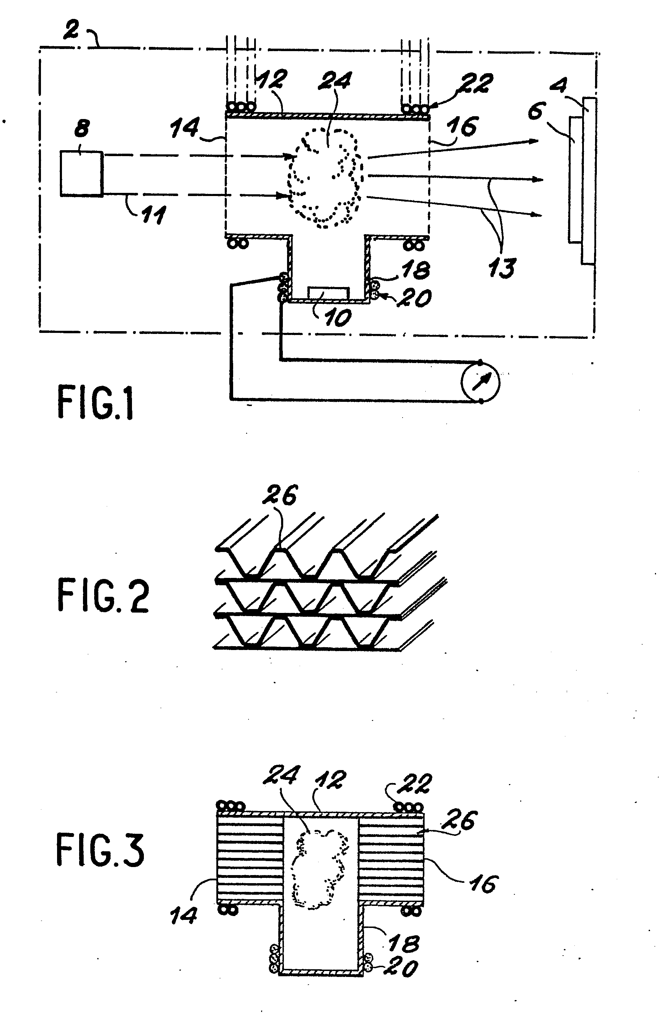

La figure 1 représente un dispositif d'implantation de particules dans un solide selon l'invention. Les différents éléments du dispositif sont placés dans une enceinte 2 sous vide. Cette enceinte 2 comprend un support de cible 4 sur lequel a été fixée une cible 6 qui constitue le solide dans lequel on désire implanter des particules. Elle comprend également une source 8 de particules énergétiques A délivrant un faisceau sensiblement parallèle 11 de particules énergétiques A. La source 8 de particules énergétiques A comprend une source de particules A et un moyen d'accélération de ces particules. Cette source 8 de particules énergétiques A a été représentée sur la figure 1 dans l'enceinte 2. Il est bien entendu que cette source 8 de particules énergétiques A peut aussi se trouver dans une autre enceinte que l'enceinte 2 communiquant par un orifice avec cette enceinte 2.

Le dispositif comprend en outre une source 10 de particules B à implanter située dans un réceptacle 18 communiquant avec un moyen de confinement 12. Les particules B engendrées par la source 10 forment un gaz 24 dont l'extension spatiale est limitée par le moyen de confinement 12 qui maintient ce gaz 24 sur la trajectoire du faisceau parallèle 11 de particules énergétiques A. La source 10 de particules B à implanter est représentée sur la figure sous la forme d'un solide. Le gaz 24 de particules B est dans ce cas obtenu par liquéfaction puis évaporation ou directement par sublimation de ce solide. Si les particules B sont à l'état liquide dans le réceptacle 18, il suffira de les évaporer. Si les particules B sont gazeuses dans les conditions de température et de pression de l'opération, la source 10 pourra être une buse ou un tube poreux relié à un réservoir de gaz de particules B situé éventuellement hors de l'enceinte 2. Enfin, on peut remplacer le gaz 24 par un flux de particules B par exemple un flux d'évaporation sous vide ou un flux de particules pulvérisées.

Le moyen de confinement 12 possède une ouverture primaire 14 permettant au faisceau sensiblement parallèle 11 de particules énergétiques A d'interagir avec les particules B du gaz 24. Il possède également une ouverture secondaire 16 qui permet aux particules B de recul 13 d'atteindre la cible 6.

Le transfert d'énergie entre les particules énergétiques A du faisceau sensiblement parallèle 11 et les particules B du gaz 24 est d'autant meilleur que le pourcentage de particules A du faisceau parallèle 11 interagissant avec les particules B est important.

Pour que ce transfert d'énergie soit optimal, il faut que le libre parcours moyen dans le gaz 24 des particules énergétiques A du faisceau sensiblement parallèle 11 soit du même ordre de grandeur que l'extension spatiale du gaz 24 dans la direction du faisceau parallèle 11 de particules énergétiques A. Ce libre parcours moyen des particules énergétiques A du faisceau sensiblement parallèle 11 est fonction de la densité du gaz 24. Cette densité peut être ajustée par les moyens de chauffage 20. Le procédé opératoire est simple. Il consiste à délivrer un faisceau sensiblement parallèle 11 de particules énergétiques A de puissance suffisante pour que les particules énergétiques A traversent le gaz 24 et atteignent la cible 6. On accroît alors la densité du gaz 24 en le chauffant par les moyens de chauffage 20 jusqu'à ce que l'on n'observe plus de particules A atteignant la cible 6.

Le moyen de confinement 12 comprend enfin des moyens de refroidissement 22 situés près de l'ouverture primaire 14 et de l'ouverture secondaire 16 qui réalisent la condensation du gaz de particules B

B 7735.3 BL

tendant à s'échapper du moyen de confinement 12. Ceci améliore le confinement du gaz 24 et évite de polluer l'enceinte 2 par des particules B.

La figure 2 représente une coupe transversale d'un multicollimateur. Ce multicollimateur est constitué de la juxtaposition de collimateurs parallèles entre eux tels que le collimateur 26. Sur la figure 2, la section de ces collimateurs 26 est trapézoïdale. Il est bien évident que cette section peut avoir une autre géométrie, par exemple circulaire, carrée, triangulaire, etc.... Ce multicollimateur peut être réalisé simplement par la superposition de tôles alternativement planes et ondulées.

La figure 3 représente un mode de réalisation particulier du moyen de confinement 12. Ce moyen de confinement 12 comprend un réceptacle 18 muni de moyens de chauffage 20, des moyens de refroidissement 22. Il comprend en outre deux multicollimateurs, l'un situé entre l'ouverture primaire 14 du moyen de confinement 12 et la zone où règne le gaz 24 de particules B à implanter, l'autre situé entre cette même zone et l'ouverture secondaire 16 du moyen de confinement 12. Ces deux multicollimateurs permettent de mieux confiner le gaz 24 dans la partie centrale du moyen de confinement 12 et donc de diminuer les pertes de gaz. L'axe des collimateurs sera préférentiellement parallèle au faisceau parallèle 11 de particules énergétiques A, ceci pour que les particules énergétiques A atteignent le gaz 24 sans interagir avec le multicollimateur, donc sans perdre d'énergie.

REVENDICATIONS

1. Procédé d'implantation de particules dans un solide dans lequel on crée un faisceau sensiblement parallèle (11) de particules énergétiques A, on place sur le chemin de ce faisceau sensiblement parallèle (11) de particules énergétiques A, des particules B qui, par interaction avec les particules énergétiques A, sont projetées vers une cible (6) avec une énergie suffisante pour y pénétrer, caractérisé en ce que les particules B sont à l'état gazeux, ce gaz (24) occupant une zone située en regard de la cible (6).

2. Procédé d'implantation de particules selon la revendication 1, caractérisé en ce que la direction du faisceau sensiblement parallèle (11) de particules énergétiques A est à peu près perpendiculaire à la surface de la cible (6).

3. Procédé d'implantation de particules selon l'une quelconque des revendications 1 et 2, caractérisé en ce que les particules A sont électriquement chargées.

4. Procédé d'implantation de particules selon l'une quelconque des revendications 1 à 3, caractérisé en ce que les particules B sont électriquement neutres.

5. Dispositif d'implantation de particules dans un solide comprenant dans une enceinte (2) sous vide un support de cible (4), une cible (6) solide, caractérisé en ce qu'il comprend en outre une source (8) de particules énergétiques A délivrant un faisceau sensiblement parallèle (11) de particules énergétiques A, une source (10) de particules B à implanter dans la cible (6), un moyen de confinement (12) des particules B communiquant avec la source (10) de particules B, comportant une ouverture primaire (14) pour recevoir le faisceau sensiblement

B 7735.3 BL

parallèle (11) de particules énergétiques A et une ouverture secondaire (16) pour éjecter les particules de recul B (13) vers la cible (6).

6. Dispositif selon la revendication 5, caractérisé en ce que le moyen de confinement (12) est de forme générale cylindrique, de génératrices parallèles à la direction du faisceau parallèle (11) de particules énergétiques A et en ce qu'il comprend un appendice (18) formant réceptacle de la source (10) de particules B.

7. Dispositif selon l'une quelconque des revendications 5 et 6, caractérisé en ce que le moyen de confinement (12) comprend un moyen de chauffage (20) du gaz (24) de particules B.

8. Dispositif selon l'une quelconque des revendications 5 à 7, caractérisé en ce que le moyen de confinement (12) est muni de moyens de refroidissement (22) pour condenser le gaz (24) de particules B.

9. Dispositif selon l'une quelconque des revendications 5 à 8, caractérisé en ce que le moyen de confinement (12) est muni d'un multicollimateur entre l'ouverture primaire (14) et la zone où règne le gaz (24) de particules B et d'un autre multicollimateur entre cette zone et l'ouverture secondaire (16).

10. Dispositif selon la revendication 9, caractérisé en ce que les deux multicollimateurs sont alignés.

0112238

1.1

FIG.1

FIG.2

FIG.3